(19) Europäisches Patentamt / European Patent Office / Office européen des brevets

(11) **EP 2 903 034 B1**

(12) **EUROPEAN PATENT SPECIFICATION**

(45) Date of publication and mention
of the grant of the patent:
**04.11.2020 Bulletin 2020/45**

(51) Int Cl.:
***H01L 31/0224*** *(2006.01)*    ***H01L 31/04*** *(2014.01)*
***H01B 1/22*** *(2006.01)*

(21) Application number: **13842803.2**

(22) Date of filing: **19.09.2013**

(86) International application number:
**PCT/JP2013/075351**

(87) International publication number:
**WO 2014/050703 (03.04.2014 Gazette 2014/14)**

(54) **CONDUCTIVE PASTE AND SOLAR CELL**

LEITFÄHIGE PASTE UND SOLARZELLE

PÂTE CONDUCTRICE ET CELLULE SOLAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.09.2012 JP 2012212643**

(43) Date of publication of application:
**05.08.2015 Bulletin 2015/32**

(73) Proprietor: **Heraeus Precious Metals North
America
Conshohocken LLC
West Conshohocken, PA 19428 (US)**

(72) Inventor: **TAKEI Shodo
Nagaokakyo-shi
Kyoto 617-8555 (JP)**

(74) Representative: **Zinnecker, Armin
Lorenz Seidler Gossel
Rechtsanwälte Patentanwälte
Partnerschaft mbB
Widenmayerstraße 23
80538 München (DE)**

(56) References cited:
**EP-A1- 2 317 523          WO-A1-2012/158905
JP-A- 2011 096 747      JP-A- 2012 084 585
US-A1- 2011 232 746**

Remarks:
The file contains technical information submitted after
the application was filed and not included in this
specification

**Description**

TECHNICAL FIELD

The present invention relates to a conductive paste and a solar cell, and more particularly relates to a conductive paste suitable for forming electrodes of a solar cell and a solar cell produced by using the conductive paste.

BACKGROUND ART

A solar cell usually has light-receiving surface electrodes of a predetermined pattern formed on one side of a main surface of a semiconductor substrate. More, an antireflective film is formed on the semiconductor substrate excluding the above-light-receiving surface electrodes, and the reflection loss of incident solar light is suppressed by the antireflective film, and thereby the conversion efficiency of solar light into electric energy is improved.

By using a conductive paste, the light-receiving surface electrodes is usually formed as follows. That is, the conductive paste contains a conductive powder, a glass frit, and an organic vehicle, and the conductive paste is applied onto a surface of an antireflective film formed on a semiconductor substrate, so that a conductive film having a predetermined pattern is formed. Subsequently, the glass frit is fused in a firing process, and the antireflective film located at a lower layer of the conductive film is decomposed and removed, and thereby the conductive film is sintered to form light-receiving surface electrodes, and the light-receiving surface electrodes and the semiconductor substrate are adhered, thereby electrically coupling them.

As described above, a method of decomposing and removing the antireflective film to adhere the semiconductor substrate and the light-receiving surface electrodes in a firing process is called a fire-through, and the conversion efficiency of a solar cell is largely dependent on the fire-through performance. That is, it is known that, when the fire-through performance is insufficient, the conversion efficiency is reduced, consequently basic performance as a solar cell is inferior.

More, in this kind of a solar cell, it is preferred to use a low-softening point glass frit in order to enhance adhesive strength between the light-receiving surface electrodes and the semiconductor substrate.

As the low-softening point glass frit, Conventionally, a lead-based glass frit has been used. However the environmental burden of lead is large, and thus, the development of new materials in place of the lead-based glass frit has been required.

On the other hand, since the conversion efficiency of a solar cell is largely dependent on the fire-through performance, as described above, it is feared that, when the fire-through advances excessively so that the sintered light-receiving surface electrodes penetrates through the antireflective film to erode the semiconductor substrate, cell characteristics are deteriorated.

Then, the document 1 proposes a conductive paste for forming electrodes of a solar cell, including a conductive powder composed mainly of silver, a glass frit, an organic vehicle, and a solvent, wherein the glass frit includes a tellurium-based glass frit containing tellurium oxide as a network-forming component.

In the document 1, since the conductive paste contains a tellurium-based glass frit, even when the firing treatment is carried out, the light-receiving surface electrodes obtained after the sintering does not deeply erode the inside of the semiconductor substrate, and therefore the control of the fire-through performance is easy, and thereby a solar cell having good cell characteristics is attempted to realize, while being a lead-free type.

Furthermore, in the document 1, the tellurium-based glass frit contains, if necessary, a tungsten oxide and a molybdenum oxide in addition to the tellurium oxide, and contains any one or more of a zinc oxide, a bismuth oxide, an aluminum oxide and the like, and thereby enlargement of vitrification range and stabilization are designed.

The document 1: JP 2011-96747A (claims 1 and 6, pars. [0021] - [0028])

SUMMARY OF INVENTION

Technical Problem

In the document 1, the contact resistance between the light-receiving surface electrodes and the semiconductor substrate is lowered by using the conductive paste containing the tellurium-based glass frit, and thereby the improvement of the cell characteristics of the solar cell is attempted. However, the contact resistance is dependent on the composition of the glass frit. That is, since the contact resistance is affected by the tellurium oxide, and other additives such as the tungsten oxide, the molybdenum oxide, and the like, it is difficult to maintain the low contact resistance stably.

The present invention has been made in view of such a situation, and it is an object of the present invention to provide a conductive paste suitable for forming solar cell electrodes that is capable of reducing the contact resistance between the electrodes and the semiconductor substrate, and a solar cell having high energy conversion efficiency and excellent cell characteristics by using the conductive paste.

Solution to Problem

In order to achieve the object, the inventor has made studies and a conductive paste is prepared so that a glass frit contains Te, Zn, Bi, and at least one element selected from the group of Li, Na and K in a predetermined range, in terms of the oxides thereof, respectively, and then the conductive paste is sintered to form electrodes, consequently, have found that it is possible to lower the contact resistance between the electrodes and the semiconductor substrate, thereby making it possible to attain a solar cell having high energy conversion efficiency and excellent cell characteristics.

The present invention has been made based on such findings, and the conductive paste according to the invention is characterized by a conductive paste for forming electrodes of a solar cell, comprising at least a conductive powder, a glass frit, and an organic vehicle, wherein the glass frit contains 35 to 90 mol% of Te in terms of $TeO_2$, 5 to 50 mol% of Zn in terms of ZnO, 1 to 20 mol% of Bi in terms of $Bi_2O_3$, and 0.1 to 15 mol% of at least one element selected from Li, Na and K in terms of oxides thereof.

The inventor has made further studies to find out that it is also possible to obtain a desired conversion efficiency by including a predetermined molar content of alkaline earth metal such as Mg, Ca, Sr and Ba in terms of oxides thereof, in the glass frit, if necessary.

That is, in the conductive paste of the present invention, it is preferable that the glass frit contains at least one element selected from the group of Mg, Ca, Sr and Ba, wherein a molar content of the Mg is 8 mol% or less in terms of an oxide thereof, a molar content of the Ca is 5 mol% or less in terms of an oxide thereof, and a molar content of the Sr and the. Ba are 3 mol% or less in terms of oxides thereof, respectively.

Furthermore, the inventor has made studies to find out that it is also possible to obtain a desired conversion efficiency by including a predetermined molar content of Mn, Cu, Ag, V, B and/or P, in terms of oxides thereof.

That is, in the conductive paste of the present invention, it is preferable that the glass frit contains at least one element selected from the group of Mn, Cu, Ag, V, B and P, wherein a molar content of the Mn and the Cu are 20 mol% or less in terms of oxides thereof, respectively, a molar content of the Ag is 10 mol% or less in terms of an oxide thereof, a molar content of the V is 8 mol% or less in terms of an oxide thereof, and a molar content of the B and the P are 3 mol% or less in terms of oxides thereof, respectively.

Moreover, in the conductive paste of the present invention, it is preferable that the glass frit contains at least one element selected from Ti, Co, Nb, Fe, Ni, Al, Zr, Ta, Si, Sn and Sb, wherein a molar content of the Ti is 10 mol% or less in terms of an oxide thereof, a molar content of the Co is 9 mol% or less in terms of an oxide thereof, and a molar content of at least one element selected from the Nb, the Fe, the Ni, the Al, the Zr, the Ta, the Si, the Sn and the Sb is 3 mol% or less in terms of oxides thereof, respectively.

Thereby, it is possible to improve chemical durability and to adjust thermophysical properties of the glass frit easily without damaging the fluidity of the glass frit when the conductive paste is fired.

In the conductive paste of the present invention, a content of the glass frit is preferably 1 to 10 wt%.

Thereby, it is possible to attain a conductive paste having excellent bondability between the electrodes and the semiconductor substrate, and excellent solderability.

In the conductive paste of the present invention, the conductive powder is preferably an Ag powder.

Thereby, it is possible to attain the electrodes having conductivity even when the conductive paste is fired in an ambient atmosphere.

Furthermore, a solar cell according to the present invention is characterized by a solar cell comprising a semiconductor substrate, an antireflective film formed on one side of a main surface of the semiconductor substrate, and electrodes penetrating through the antireflective film, wherein the electrodes is formed by sintering the above-conductive paste.

Advantageous Effects of Invention

According to the conductive paste of the present invention, it is possible to lower the contact resistance between the electrodes and the semiconductor substrate because the conductive paste comprises at least the conductive powder, the glass frit, and the organic vehicle, wherein the glass frit contains 35 to 90 mol% of Te in terms of $TeO_2$, 5 to 50 mol% of Zn in terms ZnO, 1 to 20 mol% of Bi in terms of $Bi_2O_3$, and 0.1 to 15 mol% of at least one element selected from the group of Li, Na and K in terms of oxides thereof, respectively.

Furthermore, according to the solar cell of the present invention, the contact resistance between the electrode and the semiconductor substrate can be lowered because the solar cell comprising the semiconductor substrate, the antireflective film formed on one side of main surface of the semiconductor substrate, and the electrodes penetrating through the antireflective film, wherein the electrodes is formed by sintering the above-conductive paste, and thereby it is possible to attain the solar cell having high energy conversion efficiency and excellent cell characteristics.

BRIEF EXPLANATION OF DRAWINGS

Fig. 1 is a cross-sectional view of a principal portion showing one embodiment of a solar cell produced by using a conductive paste according to the present invention.

Fig. 2 is an enlarged plan view schematically showing a light-receiving surface electrodes side.

Fig. 3 is an enlarged bottom view schematically showing a backside electrodes side.

DESCRIPTION OF EMBODIMENTS

An embodiment of the present invention will be described in detail.

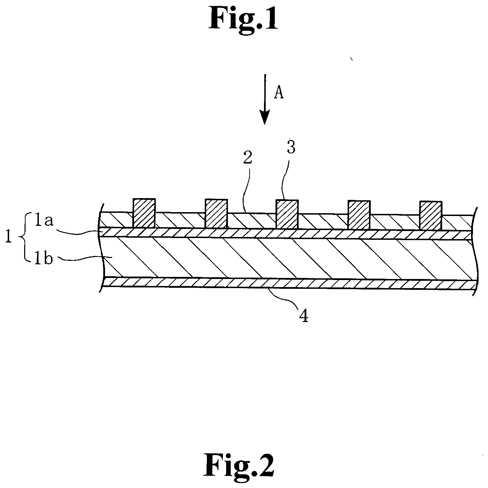

Fig.1 is a cross-sectional view of a principal portion showing an embodiment of a solar cell produced by using a conductive paste of the present invention.

In this solar cell, an antireflective film 2 and a light-receiving surface electrodes 3 are formed on one side of main surface of a semiconductor substrate 1 composed mainly of Si, and further a backside electrode 4 is formed on other side of the main surface of the semiconductor substrate 1.

The semiconductor substrate 1 has a p-type semiconductor layer 1b and an n-type semiconductor layer 1a, and the n-type semiconductor layer 1a is formed on the upper surface of the p-type semiconductor layer 1b.

The semiconductor substrate 1 can be obtained, for example, by diffusing impurities into one side of the main surface of the p-type semiconductor layer 1b of a monocrystal or polycrystal, and thereby, a thin n-type semiconductor layer 1a formed. Further, the semiconductor substrate 1 is not particularly limited regarding the structure and the production method thereof as long as the n-type semiconductor layer 1a is formed on the upper surface of the p-type semiconductor layer 1b. The semiconductor substrate 1 may be use substrate having a structure such that a thin p-type semiconductor layer is formed on one side of the main surface of an n-type semiconductor layer, or a structure such that both of a p-type semiconductor layer and an n-type semiconductor layer are formed on a part of one side of the main surface of the semiconductor substrate 1. In any case, the conductive paste of the present invention can be used effectively as long as the main surface of the semiconductor substrate 1 on which is formed the antireflective film 2 is applied.

In Fig.1, although the surface of the semiconductor substrate 1 is illustrated to a flat-shape, the surface is formed so as to have a texture structure in order to confine solar light into the semiconductor substrate 1 effectively.

The antireflective film 2 is composed of an insulating material such as a silicon nitride (SiNx), and suppresses reflection of solar light showed by an arrow A on the light-receiving surface to guide solar light promptly and effectively to the semiconductor substrate 1. The material composed of the antireflective film 2 is not limited to the silicon nitride, and other insulating materials, for example, a silicon oxide or a titanium oxide, may be used, and also a combination of two or more insulating materials may be used. Further, any one of single crystal Si and polycrystal Si may be used as long as it is a crystal Si-based material.

The light-receiving surface electrodes 3 are formed on the semiconductor substrate 1 to penetrate through the antireflective film 2. The light-receiving surface electrodes 3 are formed by using screen printing or the like, applying the conductive paste of the present invention described later onto the semiconductor substrate 1 to produce a conductive film, and subsequently firing. That is, the antireflective film 2 located at the lower layer of the conductive film is decomposed and removed to undergo a fire-through in the firing step of forming the light-receiving surface electrodes 3, and thereby the light-receiving surface electrodes 3 are formed on the semiconductor substrate 1 in the form of penetrating through the antireflective film 2.

Specifically, as illustrated in Fig. 2, in the light-receiving surface electrodes 3, many finger electrodes 5a, 5b, ...... 5n are arranged in parallel in a comb-teeth shape, and a bus bar electrode 6 is arranged to intersect the finger electrodes 5a, 5b, ...... 5n. The finger electrodes 5a, 5b, ...... 5n are electrically connected to the bus bar electrode 6. The antireflective film 2 is formed in a remaining area excluding a portion where the light-receiving surface electrodes 3 is provided. In this way, the electric power generated in the semiconductor substrate 1 is collected through the finger electrodes 5a, 5b, ...... 5n, and extracted to the outside through the bus bar electrode 6.

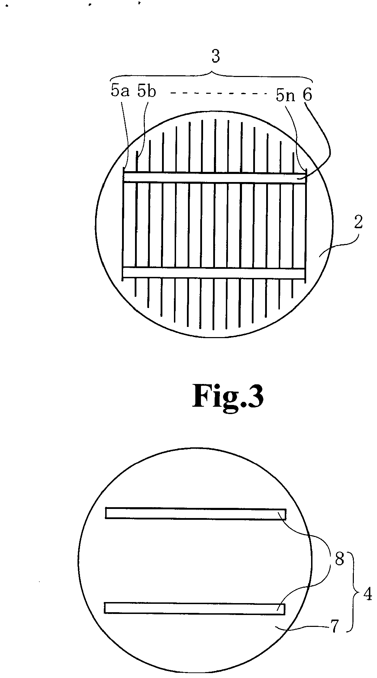

The backside electrode 4, as illustrated in Fig.3, specifically, consists of a collecting electrode 7 composed of Al or the like which is formed on the back surface of the p-type semiconductor layer 1b, and extraction electrodes 8 composed of Ag or the like which is connected electrically to the collecting electrode 7. The electric power generated in the semiconductor substrate 1 is collected to the collecting electrode 7, and then extracted the electric power through the extraction electrodes 8.

Next, the conductive paste of the present invention for forming the light-receiving surface electrode 3 will be described in detail.

The conductive paste of the present invention contains at least a conductive powder, a glass frit, and an organic vehicle.

The glass frit further contains 35 to 90 mol% of Te in terms of $TeO_2$, 5 to 50 mol% of Zn in terms of ZnO, 1 to 20 mol% of Bi in terms of $Bi_2O_3$, and 0.1 to 15 mol% of at least one element selected from the group of Li, Na and K in terms of oxides thereof, respectively.

Thereby, it is possible to lower the contact resistance between the light-receiving surface electrodes 3 and the semiconductor substrate 1 and consequently capable of obtaining a solar cell having high energy conversion efficiency and excellent cell characteristics.

Hereinafter, the reasons that the molar content of Te, Zn, Bi, and at least one element selected from the grope of Li, Na and K in the glass frit is limited to the above-mentioned range will be described.

(1) Molar content of Te

Glass is composed of a network former oxide which is amorphized to form a network structure, a modifier oxide which modifies the network former oxide to be made amorphous, and an intermediate oxide having an intermediate function between the network former and the modifier oxide. Of these, $TeO_2$ acts as the network former oxide and further the light-receiving surface electrodes after the sintering do not deeply erode the inside of the semiconductor substrate, and therefore the control of the fire-through performance is easy, and an important constituent component can be formed.

However, when the molar content of Te in terms of $TeO_2$ is less than 35 mol%, it is difficult to ensure a desired fire-through performance. On the other hand, when the molar content of Te in terms of $TeO_2$ is more than 90 mol%, the molar content of the other glass components becomes small extremely, so that the it is difficult to vitrify.

Thus, in the present embodiment, the molar content of Te in the glass frit is set to 35 to 90 mol%, in terms of $TeO_2$.

(2) Molar content of Zn

ZnO acts as an intermediate oxide, and in case of the firing of the conductive paste, the decomposition and removal of the antireflective film 2 is advanced and being capable of performing a smooth fire-through, thereby contributing a lowering of the contact resistance between the light-receiving surface electrodes 3 and the semiconductor substrate 1.

However, when the molar content of Zn in terms of ZnO is less than 5 mol%, it is fear that a desired smooth fire-through performance cannot be ensured. On the other hand, when the molar content of Zn in terms of ZnO is more than 50 mol%, the molar content of the other glass components such as Te, Bi, and the like is relatively decreased and it is not preferable.

Thus, in the present embodiment, the molar content of Zn in the glass frit is set to 5 to 50 mol%, in terms of ZnO.

(3) Molar content of Bi

$Bi_2O_3$ acts to adjust the fluidity of glass, as the modifier oxide, and also contributes to the advance of the fire-through performance.

In order to advance the fire-through performance, the molar content of Bi is needed at least 1 mol% and more, in terms of $Bi_2O_3$. On the other hand, when the molar content of Bi is more than 20 mol%, in terms of $Bi_2O_3$, it is difficult to vitrify.

Thus, in the present embodiment, the molar content of Bi in the glass frit is set to 1 to 20 mol%, in terms of $Bi_2O_3$.

(4) Molar content of Li, Na and K

$Li_2O$, $Na_2O$, and $K_2O$, as a modifier oxide, have a function of adjusting the softening point of glass, as well as $Bi_2O_3$, and advance crystallization in an appropriate temperature range, and therefore contribute to the improvement of fire-through performance.

For this purpose, it is necessary to contain 0.1 mol% or more of at least one element selected from the group of Li, Na and K, in terms of oxides thereof. On the other hand, when the molar content of these elements is exceed more than 15 mol%, in terms of oxides thereof, it is fear that chemical durability is deteriorated.

Thus, in the present embodiment, the molar content of at least one element selected from the group of Li, Na and K in the glass frit is set to 0.1 to 15 mol%, in terms of oxides thereof.

In the present invention, it is also preferred to contain various additives other than the Te, the Zn, the Bi, the Li, the Na and the K, if necessary.

According to the present invention, the glass frit contains at least one element selected from the group of Mg, Ca, Sr and Ba.

In that respect, an oxide containing an alkaline earth metal such as Mg, Ca, Sr, and Ba, as the modifier oxide, has the action of adjusting the fluidity of glass and also contributes to the advance of the fire-through performance, and therefore, at least one of the above-alkaline earth metals is included in the glass frit.

In that respect, in case of including the Mg, the molar content thereof is 8 mol% or less in terms of MgO; in case of including the Ca, the molar content thereof is 5 mol% or less in terms of CaO; and in case of including the Sr and the Ba, the molar content thereof are 3 mol% or less in terms of SrO and BaO, respectevely. That is, If the alkaline earth metals are included the molar content more than the above-mentioned range in the glass frit, the fire-through performance is conversely deteriorated, so that the contact resistance may be increased, and the conversion efficiency may be lowered.

Furthermore, Mn, Cu, Ag, V, B, P, or the like also contribute to the advance of the fire-through performance; and therefore it is preferred to include at least one selected from the group of the above-elements into the glass frit, if necessary.

It is however preferred that in case of including the Mn and the Cu, the molar content of the Mn and the Cu are 20 mol% or less, in terms of $MnO_2$ and CuO, respectively; in case of including the Ag, the molar content of the Ag is 10 mol% or less, in terms of $Ag_2O$; in case of including the V, the molar content of the V is 8 mol% or less, in terms of $V_2O_5$; and in case of including the B and the P, the molar content of the B and the P are 3 mol% or less, in terms of $B_2O_3$ and $P_2O_5$, respectively. If these elements are included the molar content more than the above-mentioned range, the fire-through performance is conversely deteriorated, so that the contact resistance may be increased, and the conversion efficiency may be lowered.

Moreover, Ti, Nb, Fe, Co, Ni, Al, Zr, Ta, Si, Sn, Sb or the like contribute to the improvement of chemical durability of the glass frit, and therefore it is preferred to include these elements into the glass frit, if necessary.

It is however preferred that in case of including the Ti, the molar content of the Ti is 10 mol% or less, in terms of $TiO_2$; in case of the Co, the molar content of the Co is 9 mol% or less, in terms of CoO; in case of including the Nb, the Fe, the Ni, the Al, the Zr, the Ta, the Si, the Sn and the Sb, the molar content of these elements are 3 mol% or less, in terms of $Nb_2O_5$, $Fe_2O_3$, NiO, $Al_2O_3$, $ZrO_2$, $Ta_2O_5$, $SiO_2$, $SnO_2$ and $Gb_2O_3$, respectively. When the molar content of the above-elements is exceed more than the above-mentioned range, it is fear that it is difficult to vitrify.

Besides, the addition form of these additives is not particularly limited, and the additive may be added in the form of, for example, an oxide, a hydroxide, a peroxide, a halide, a carbonate, a nitrate, a phosphate, a sulfate or a fluoride.

Although the content of the glass frit in the conductive paste is not particularly limited, it is preferably 1 to 10 wt%, more preferably 1 to 5 wt%. When the content of the glass frit is less than 1 wt%, the bondability between the electrodes and the semiconductor substrate may be lowered. On the other hand, when the content of the glass frit is more than 10 wt%, the glass component is excessively present on the electrodes surface after the firing, thereby causing the degradation of the solderability.

Although the conductive powder is not particularly limited as long as it is a metal powder having excellent conductivity, an Ag powder which can maintain excellent conductivity without being oxidized even when the firing treatment is carried out in an ambient atmosphere, may be preferably used. In addition, the shape of the conductive powder is not also particularly limited, and, for example, a spherical shape, a flattened shape, or an amorphous shape, or a mixture thereof can be used.

Although the average particle diameter of the conductive powder is not particularly limited, it is preferably 0.5 to 5.0 $\mu$m, in terms of a spherical powder, in view of ensuring a desired contact point between the conductive powder and the semiconductor substrate 1.

More, although the content of the conductive powder in the conductive paste is not particularly limited, it is preferably 80 to 95 wt%. When the content of the conductive powder is less than 80 wt%, a film thickness of the electrodes becomes thinner, as a result, the line resistance tends to increase. On the other hand, when the content of the conductive powder is more than 95 wt%, the content of the organic vehicle or the like is decreased, and therefore pasting becomes difficulty.

The organic vehicle is prepared in such a manner that a volume ratio between a binder resin and an organic solvent is, for example, 1:9 to 3:7. The binder resin is not particularly limited, and for example, an ethyl cellulose resin, a nitrocellulose resin, an acrylic resin, an alkyd resin, and any combination of two or more of these resins can be used. The organic solvent is not also particularly limited, and texanol, $\alpha$-terpineol, xylene, toluene, diethylene glycol monobutyl ether, diethylene glycol monobutyl ether acetate, diethylene glycol monoethyl ether, diethylene glycol monoethyl ether acetate, and the like can be used singly, or in combination thereof.

In addition, it is also preferred to add, a kind of plasticizer such as diethylhexyl phthalate or dibutyl phthalate, or a combination of two or more thereof in the conductive paste, if necessary. It is also preferred that a rheology-adjusting agent such as fatty acid amide or fatty acid is added, and further a thixotropic agent, a thickening agent, a dispersing agent or the like may be added.

The conductive paste can be easily produced by weighing and mixing the conductive powder, the glass frit, the organic vehicle, and further various additives, if necessary, so as to have a predetermined mixture ratio, and dispersing and kneading by using a triple roll mill or the like.

As described above, in the present conductive paste, it is possible to lower the contact resistance between the light-surface electrodes 3 and the semiconductor substrate 1 because a conductive paste comprises at least a conductive powder, a glass frit, and an organic vehicle, wherein the glass frit contains 35 to 90 mol% of Te in terms of $TeO_2$, 5 to 50 mol% of Zn in terms of ZnO, 1 to 20 mol% of Bi in terms of $Bi_2O_3$, and 0.1 to 15 mol% of at least one element selected from the group of Li, Na and K in terms of oxides thereof, respectively.

When the above-mentioned various additives are included in the predetermined molar content range, the contact resistance between the light-receiving surface electrode 3 and the semiconductor substrate 1 can be lowered without damaging chemical durability of the glass frit, and conversion efficiency can be improved.

In the present solar cell, the contact resistance between the electrode and the semiconductor substrate can be lowered because the solar cell comprises a semiconductor substrate, the antireflective film formed on one side of main surface of the semiconductor substrate, and the electrodes penetrating through the antireflective film, wherein the electrodes are formed by sintering the above-conductive paste, and thereby it is possible to attain the solar cell having high energy conversion efficiency and excellent cell characteristics.

Besides the present invention is not limited to this embodiment. For example, the constituent components of the conductive paste can be included the various inorganic additives as long as the cell characteristics are not affected.

In the above-embodiment, although the conductive paste is used for forming the light-receiving surface electrodes, it may be further used for forming the backside electrode.

Next, examples of the present invention will be described specifically.

EXAMPLE

Production of Samples

(Production of conductive paste)

As materials for glass, $TeO_2$, ZnO, $Bi_2O_3$, $Li_2O$, $Na_2O$, $K_2O$, MgO, CaO, SrO, BaO, $MnO_2$, CuO, $Ag_2O$, $B_2O_3$, $V_2O_5$, $P_2O_5$, $TiO_2$, $Nb_2O_5$, $Fe_2O_3$, CoO, NiO, $Al_2O_3$, $ZrO_2$, $Ta_2O_5$, $SiO_2$, $SnO_2$, $Sb_2O_5$ and $MoO_3$ were prepared. These glass materials were weighed and prepared to have a blend proportion, as shown in Table 1, and thereby a glass frit of sample Nos. 1 to 26 was produced, respectively.

Table 1

| Sample No. | TeO2 | ZnO | Bi2O3 | Li2O | Na2O | K2O | MgO | CaO | SrO | BaO | MnO2 | CuO | Ag2O | B2O3 | V2O5 | P2O5 | TiO2 | Nb2O5 | Fe2O3 | CoO | NiO | Al2O3 | ZrO2 | Ta2O5 | SiO2 | SnO2 | Sb2O3 | MoO3 |
|---|---|---|---|---|---|---|---|---|---|---|---|---|---|---|---|---|---|---|---|---|---|---|---|---|---|---|---|---|
| | Glass composition(mol%) | | | | | | | | | | | | | | | | | | | | | | | | | | | |
| 1 | 88.9 | 5.0 | 1.0 | 4.5 | 0.1 | 0.1 | - | - | - | - | - | - | - | - | - | - | - | - | - | - | - | 0.4 | - | - | - | - | - | - |
| 2 | 55.0 | 25.0 | 4.5 | - | 10.0 | - | - | 5.0 | - | - | - | - | - | - | - | - | - | - | - | - | - | 0.5 | - | - | - | - | - | - |
| 3 | 35.0 | 50.0 | 7.6 | 2.2 | 2.2 | - | - | - | - | - | - | - | - | - | - | - | - | - | 3.0 | - | - | - | - | - | - | - | - | - |
| 4 | 71.5 | 7.0 | 8.5 | - | - | 10.0 | - | - | - | - | - | - | - | - | - | - | - | 3.0 | - | - | - | - | - | - | - | - | - | - |
| 5 | 49.2 | 22.6 | 10.2 | 0.1 | 4.9 | - | - | - | - | - | - | - | 10.0 | - | - | 3.0 | - | - | - | - | - | - | - | - | - | - | - | - |
| 6 | 46.2 | 36.6 | 8.8 | - | 0.1 | 5.0 | - | - | - | - | - | - | - | 0.3 | - | - | - | - | - | - | - | - | 3.0 | - | - | - | - | - |
| 7 | 45.0 | 22.1 | 19.9 | 10.0 | - | - | - | - | - | - | - | - | - | - | - | - | - | - | - | - | - | 3.0 | - | - | - | - | - | - |
| 8 | 53.0 | 23.0 | 10.0 | - | 3.0 | - | - | - | 3.0 | - | - | - | - | - | 8.0 | - | - | - | - | - | - | - | - | - | - | - | - | - |
| 9 | 54.0 | 21.0 | 11.0 | - | - | 3.0 | 8.0 | - | - | - | - | - | - | - | - | - | - | - | - | - | - | - | - | - | - | - | 3.0 | - |
| 10 | 40.8 | 33.7 | 10.4 | - | 2.1 | - | - | - | - | - | - | - | - | 3.0 | - | - | 10.0 | - | - | - | - | - | - | - | - | - | - | - |
| 11 | 43.4 | 17.5 | 14.1 | 5.0 | - | - | - | - | - | - | 20.0 | - | - | - | - | - | - | - | - | - | - | - | - | - | - | - | - | - |
| 12 | 48.0 | 33.5 | 7.5 | - | - | 4.8 | - | 0.5 | - | - | - | - | - | - | - | - | - | - | - | - | 3.0 | - | 0.2 | - | - | - | - | - |
| 13 | 52.0 | 21.3 | 16.5 | 3.7 | - | - | - | 0.5 | - | 3.0 | - | - | - | - | - | - | - | - | - | - | - | - | - | - | 3.0 | - | - | - |
| 14 | 51.4 | 25.0 | 10.0 | - | 4.6 | - | - | - | - | - | - | - | - | - | - | - | - | - | - | 9.0 | - | - | - | - | - | - | - | - |
| 15 | 43.5 | 22.7 | 7.8 | 6.0 | - | - | - | - | - | - | - | 20.0 | - | - | - | - | - | - | - | - | - | - | - | - | - | - | - | - |
| 16 | 44.8 | 37.7 | 12.8 | - | 1.0 | 0.7 | - | - | - | - | - | - | - | - | - | - | - | - | - | - | - | - | - | - | - | 3.0 | - | - |
| 17 | 70.0 | 7.3 | 2.1 | 15.0 | - | - | - | - | - | - | - | 2.5 | - | - | - | - | - | - | - | - | - | - | - | 3.0 | - | - | - | - |
| 18 | 63.1 | 11.6 | 7.3 | 2.5 | 15.0 | - | - | - | - | - | - | - | 1.0 | - | - | - | - | - | - | - | - | - | 0.5 | - | - | - | - | - |
| 19 | 54.1 | 19.3 | 5.4 | 3.7 | - | 15.0 | - | - | - | 1.5 | - | - | 1.0 | - | - | - | - | - | - | - | - | - | - | - | - | - | - | - |
| 20*2) | 52.4 | 23.8 | 4.3 | - | 9.5 | - | - | 9.5 | - | - | - | - | - | - | - | - | - | - | - | - | - | 0.5 | - | - | - | - | - | - |
| 21*2) | 51.0 | 22.1 | 9.6 | - | 2.9 | - | 11.5 | - | - | - | - | - | - | - | - | - | - | - | - | - | - | - | - | - | 2.9 | - | - | - |
| 22*2) | 50.0 | 20.5 | 15.9 | 3.6 | - | - | - | 0.5 | - | 6.7 | - | - | - | - | - | - | - | - | - | - | - | 2.9 | - | - | - | - | - | - |
| 23*3) | 39.2 | 32.4 | 10.0 | - | 2.0 | - | - | - | - | - | - | - | - | 6.7 | - | - | 9.6 | - | - | - | - | - | - | - | - | - | - | - |
| 24*3) | 40.6 | 16.4 | 13.2 | 4.7 | - | - | - | - | - | - | 25.2 | - | - | - | - | - | - | - | - | - | - | - | - | - | - | - | - | - |
| 25*3) | 40.3 | 21.0 | 7.2 | 5.6 | - | - | - | - | - | - | - | 25.9 | - | - | - | - | - | - | - | - | - | - | - | - | - | - | - | - |
| 26*1) | 70.0 | - | 10.0 | - | - | - | - | - | - | - | - | - | - | - | - | - | - | - | - | - | - | - | - | - | - | - | - | 20.0 |

*1) indicates outside the scope of claim 1
*2) indicates outside the scope of claim 2
*3) indicates outside the scope of claim 3

As a conductive powder, a spherical Ag powder having an average particle diameter of 1.6 μm was prepared.

Then, an organic vehicle was produced. That is, an ethyl cellulose resin and texanol were mixed so that an ethyl cellulose resin as a binder resin was 10 wt% and texanol as an organic solvent was 90 wt% to produce an organic vehicle.

Then, 86.0 wt% of the Ag powder and 3.0 wt% of the glass frit were mixed together with a rheology-adjusting agent such as an aliphatic acid amide, aliphatic acid, or the like and the organic vehicle, and the resulting mixture was mixed with a planetary mixer and then kneaded with a triple roll mill to produce conductive pastes of sample Nos. 1 to 26.

(Production of solar cells)

An antireflective film having a film thickness of 0.1 μm was formed on the entire surface of a monocrystal Si-based semiconductor substrate having a length of 50 mm, a width of 50 mm and a thickness of 0.2 mm by plasma-enhanced chemical vapor deposition method (PECVD). In the Si-based semiconductor substrate, a phosphorus (P) is diffused into a part of a p-type Si-based semiconductor layer, and thereby an n-type Si-based semiconductor layer is formed on the upper surface of the p-type Si-based semiconductor layer.

Next, an Al paste composed mainly of Al, and an Ag paste composed mainly of Ag were prepared. The Al paste and the Ag paste were applied onto the back surface of the Si-based semiconductor substrate appropriately, and the resultant was dried, thereby forming a conductive film for backside electrode.

Next, Using the above-mentioned conductive paste, screen printing was performed, and was applied onto the surface of the Si-based semiconductor substrate so that a film thickness after the firing becomes 20 μm, and thereby a conductive film for light-receiving surface electrodes was produced.

Next, each of the samples was put into an oven which set to a temperature of 150°C, and dried the conductive film.

Thereafter, with use of a belt-type near infrared furnace (CDF7210, manufactured by Despatch), the conveying speed of the sample was adjusted so that the sample passed through about one minute from the inlet to the outlet, and was fired at a maximum firing temperature of 760 to 800°C in an ambient atmosphere, and thereby a solar cell of sample Nos. 1 to 26 on which the conductive paste was sintered to form light-receiving surface electrodes, was produced respectively. The reason the maximum firing temperature was set to 760 to 800°C is that the maximum firing temperature optimal for such a paste is varied in accordance with the composition thereof.

Evaluation of Samples

In each of the sample Nos. 1 to 26, using a solar simulator (SS-50XIL, manufactured by EKO Instruments), a current-voltage characteristic curve under conditions of a temperature of 25°C and an AM (air mass) of 1.5 was measured, and then, the fill factor FF of the sample was calculated based on the current-voltage characteristic curve, in accordance with the mathematical formula (1).

$$FF = Pmax/(V_{OC} \times I_{SC}) \ldots (1)$$

Wherein Pmax is the maximum power of the sample; $V_{OC}$ is an open-circuit voltage generated when the output terminals are opened; and $I_{SC}$ is a short circuit current generated when the output terminals are short-circuited therebetween.

The conversion efficiency η of the sample was calculated based on the maximum power Pmax, an area A of the light-receiving surface electrodes, and an irradiance E, in accordance with the mathematical formula (2).

$$\eta = Pmax (A \times E) \ldots (2)$$

Table 2 shows the paste composition, the fill factor FF, the conversion efficiency η, and the evaluation result of the sample Nos. 1 to 26, respectively. In the evaluation results, a sample that had a fill factor FF of 0.76 or more and a conversion efficiency η of 16.40% or more was judged to be excellent (◎); a sample that had a fill factor FF of 0.72 or more and less than 0.76 and a conversion efficiency η of 15.60 or more and less than 16.40 was judged to be good (○); and a sample that had a fill factor FF of less than 0.72 and a conversion efficiency η of less than 15.60 was judged to be no-good (X).

In the sample No. 26, the fill factor FF was as low as 0.712, and the conversion factor η was as low as 15.12%. The reason for this is thought that the, in the glass frit, any of ZnO, $Li_2O$, $Na_2O$ and $K_2O$ is not contained, while $MoO_3$, which is outside the scope of the present invention, is contained, and thus, the fire-through performance is inferior, so that the contact resistance is increased, and the cell characteristics are deteriorated.

On the other hand, in the sample Nos. 1 to 25, the molar content of $TeO_2$ was 35.0 to 88.9 mol%, the molar content of ZnO was 5.0 to 50.0 mol%, the molar content of $Bi_2O_3$ was 1.0 to 19.9 mol%, and the molar content of $Li_2O$, $Na_2O$ or $K_2O$ was 0.1 to 15.0 mol%, and any of these contents fall within the scope of the present invention, and therefore the fill factor FF was 0.736 to 0.786, and the conversion factor η was 15.74 to 16.84%, so that good or excellent results were obtained.

Table 2

| Sample No. | Cell characteristics | | Evaluation |
|---|---|---|---|
| | Fill factor FF | Conversion factor η (%) | |
| 1 | 0.782 | 16.75 | ◎ |
| 2 | 0.782 | 16.75 | ◎ |
| 3 | 0.784 | 16.79 | ◎ |
| 4 | 0.781 | 16.73 | ◎ |
| 5 | 0.784 | 16.81 | ◎ |
| 6 | 0.779 | 16.68 | ◎ |
| 7 | 0.785 | 16.82 | ◎ |
| 8 | 0.777 | 16.64 | ◎ |
| 9 | 0.775 | 16.59 | ◎ |
| 10 | 0.784 | 16.79 | ◎ |
| 11 | 0.778 | 16.66 | ◎ |
| 12 | 0.776 | 16.62 | ◎ |
| 13 | 0.786 | 16.84 | ◎ |
| 14 | 0.777 | 16.64 | ◎ |
| 15 | 0.786 | 16.84 | ◎ |
| 16 | 0.781 | 16.73 | ◎ |
| 17 | 0.781 | 16.75 | ◎ |
| 18 | 0.775 | 16.57 | ◎ |
| 19 | 0.776 | 16.65 | ◎ |
| 20*2) | 0.755 | 16.16 | ○ |
| 21*2) | 0.751 | 16.07 | ○ |
| 22*2) | 0.749 | 16.02 | ○ |
| 23*3) | 0.757 | 16.20 | ○ |
| 24*3) | 0.743 | 15.89 | ○ |
| 25*3) | 0.736 | 15.74 | ○ |
| 26*1) | 0.712 | 15.21 | × |

* Vindicates outside the scope of claim 1
*2)indicates outside the scope of claim 2
*3)indicates outside the scope of claim 3

In particular, in the sample Nos. 1 to 19, various additives such as alkaline earth oxides were also contained within the preferred scope of the present invention, and thus, the fill factor FF was 0.775 or more, and the conversion factor η was 16.57% or more, so that excellent results were obtained.

.On the other hand, in the sample Nos. 20 to 22, the molar content of the alkaline earth oxide were outside of preferred scope of the present invention, and thus, it was understood that, although the samples were good and were able to ensure practicability, the contact resistance between the light-receiving surface electrodes and the semiconductor substrate was increased slightly, and the fill factor FF and the conversion efficiency were deteriorated slightly.

More, in the sample Nos. 23 to 25, the molar content of any of $B_2O_5$, $MnO_2$ and CuO were outside of the preferred scope of the present invention, and thus, it was understood that, although the samples were good and were able to ensure practicability, the contact resistance between the light-receiving surface electrode and the semiconductor substrate was increased slightly, and the fill factor FF and the conversion efficiency were deteriorated slightly, as well as the sample Nos. 20 to 22,

As described above, it was understood that the contact resistance between the light-receiving surface electrode and the semiconductor substrate can be lowered, and excellent cell characteristics can be obtained when the molar content of Te, Zn, Bi, and at least one element selected from the group of Li, Na and K fall within the scope of the present invention. It was also understood that further excellent cell characteristics can be obtained by including the various additives within the preferred scope of the present invention.

INDUSTRIAL APPLICABILITY

the contact resistance between electrodes and the semiconductor substrate can be lowered, and thereby it is possible to attain the solar cell having high energy conversion efficiency and excellent cell characteristics.

REFERENCE SIGNS LIST

1    Semiconductor substrate

2    Antireflective film

3    Light-receiving surface electrode (electrode)

**Claims**

1.  A conductive paste for forming electrodes of a solar cell, comprising at least:

    a conductive powder;
    a glass frit;
    and an organic vehicle,

    wherein the glass frit contains 35 to 90 mol% of Te in terms of $TeO_2$, 5 to 50 mol% of Zn in terms of ZnO, 1 to 20 mol% of Bi in terms of $Bi_2O_3$, and 0.1 to 15 mol% of at least one element selected from the group of Li, Na and K in terms of oxides thereof, respectively.

2.  The conductive paste according to claim 1, wherein the glass frit contains at least one element selected from the group of Mg, Ca, Sr and Ba,
    wherein a molar content of the Mg is 8 mol% or less in terms of an oxide thereof, a molar content of the Ca is 5 mol% or less in terms of an oxide thereof, and a molar content of the Sr and the Ba are 3 mol% or less in terms of oxides thereof, respectively.

3.  The conductive paste according to claim 1 or 2, wherein the glass frit contains at least one element selected from the group of Mn, Cu, Ag, V, B and P,
    wherein the molar content of the Mn and the Cu are 20 mol% or less in terms of oxides thereof, respectively, the molar content of the Ag is 10 mol% or less in terms of an oxide thereof, the molar content of the V is 8 mol% or less in terms of an oxide thereof, and the molar content of the B and the P are 3 mol% or less in terms of oxides thereof, respectively.

4.  The conductive paste according to any one of claims 1 to 3, wherein the glass frit contains at least one element selected from the group of Ti, Co, Nb, Fe, Ni, Al, Zr, Ta, Si, Sn and Sb,
    wherein a molar content of the Ti is 10 mol% or less in terms of an oxide thereof, a molar content of the Co is 9 mol% or less in terms of an oxide thereof, and a molar content of at least one element selected from the group of the Ti, the Co, the Nb, the Fe, the Ni, the Al, the Zr, the Ta, the Si, the Sn and the Sb is 3 mol% or less in terms of oxides thereof, respectively.

5.  The conductive paste according to any one of claims 1 to 4, wherein a content of the glass frit is 1 to 10 wt%.

**6.** The conductive paste according to any one of claims 1 to 5, wherein the conductive powder is an Ag powder.

**7.** A solar cell comprising:

a semiconductor substrate,
an antireflective film formed on one side of main surface of the semiconductor substrate, and
electrodes penetrating through the antireflective film,
wherein the electrodes is formed by sintering the conductive paste according to any one of claims 1 to 6.

**Patentansprüche**

**1.** Leitfähige Paste zur Bildung von Elektroden einer Solarzelle, aufweisend zumindest:

ein leifähiges Pulver;
eine Glasfritte;
und ein organisches Vehikel,
wobei die Glasfritte jeweils 35 bis 90 Molprozent an Te in Bezug auf TeO$_2$, 5 bis 50 Molprozent an Zn in Bezug auf ZnO, 1 bis 20 Molprozent an Bi in Bezug auf Bi$_2$O$_3$, und 0,1 bis 15 Molprozent von zumindest einem Element ausgewählt aus der Gruppe von Li, Na und K in Bezug auf Oxide davon enthält,
wobei die Glasfritte zumindest ein Element ausgewählt aus der Gruppe aus Mg, Ca, Sr und Ba enthält,
wobei ein Molgehalt des Mg 8 Molprozent oder weniger in Bezug auf ein Oxid davon ist, ein Molgehalt des Ca 5 Molprozent oder weniger in Bezug auf ein Oxid davon ist, und ein Molgehalt des Sr und des Ba 3 Molprozent oder weniger in Bezug auf Oxide davon ist.

**2.** Leitfähige Paste nach Anspruch 1, wobei die Glasfritte zumindest ein Element ausgewählt aus der Gruppe aus Mn, Cu, Ag, V, B und P enthält,
wobei der Molgehalt des Mn und des Ci jeweils 20 Molprozent oder weniger in Bezug auf Oxide davon ist, der Molgehalt des Ag 10 Molprozent oder weniger in Bezug auf ein Oxid davon ist, der Molgehalt des V 8 Molprozent oder weniger in Bezug auf ein Oxid davon ist, und der Molgehalt des B und des P jeweils 3 Molprozent oder weniger in Bezug auf Oxide davon ist.

**3.** Leitfähige Paste nach einem der Ansprüche 1 oder 2, wobei die Glasfritte zumindest ein Element ausgewählt aus der Gruppe von Ti, Co, Nb, Fe, Ni, Al, Zr, Ta, Si, Sn und Sb enthält,
wobei ein Molgehalt des Ti 10 Molprozent oder weniger in Bezug auf ein Oxid davon ist, ein Molgehalt des Co 9 Molprozent oder weniger in Bezug auf ein Oxid davon ist, und ein Molgehalt von zumindest einem Element ausgewählt aus der Gruppe des Ti, des Co, des Nb, des Fe, des Ni, des Al, des Zr, des Ta, des Si, des Sn und des Sb jeweils 3 Molprozent oder weniger in Bezug auf Oxide davon ist.

**4.** Leitfähige Paste nach einem der Ansprüche 1 bis 3, wobei ein Gehalt der Glasfritte 1 bis 10 Gewichtsprozent beträgt.

**5.** Leifähige Paste nach einem der Ansprüche 1 bis 4, wobei das leitfähige Pulver ein Ag-Pulver ist.

**6.** Solarzelle, aufweisend:

ein Halbleitersubstrat,
eine Antireflexionsfolie, die auf einer Seite einer Hauptfläche des Halbleitersubstrats gebildet ist, und
Elektroden, die die Antireflexionsfolie durchdringen,
wobei die Elektroden durch Sintern der leitfähigen Paste gemäß einem der Ansprüche 1 bis 5 gebildet ist.

**Revendications**

**1.** Pâte conductrice destinée à former des électrodes d'une cellule solaire, comprenant au moins :

une poudre conductrice ;
une fritte de verre, et
un véhicule organique,

dans laquelle la fritte de verre contient de 35 à 90 % en moles de Te en termes de $TeO_2$, 5 à 50 % en moles de Zn en termes de ZnO, 1 à 20 % en moles de Bi en termes de $Bi_2O_3$, et 0,1 à 15 % en moles d'au moins un élément sélectionné parmi le groupe en Li, Na et K en termes d'oxydes de ceux-ci ;
dans laquelle la fritte de verre contient au moins un élément sélectionné parmi le groupe en Mg, Ca, Sr et Ba, et dans laquelle respectivement, une teneur molaire du Mg est inférieure ou égale à 8 % en moles en termes d'un oxyde de celui-ci, une teneur molaire du Ca est inférieure ou égale à 5 % en moles en termes d'un oxyde de celui-ci, et une teneur molaire du Sr et du Ba est inférieure ou égale à 3 % en moles en termes d'oxydes de ceux-ci.

2. Pâte conductrice selon la revendication 1, dans laquelle la fritte de verre contient au moins un élément sélectionné parmi le groupe en Mn, Cu, Ag, V, B et P, et
dans laquelle respectivement, la teneur molaire du Mn et du Cu est inférieure ou égale à 20 % en moles en termes d'oxydes de ceux-ci, la teneur molaire de l'Ag est inférieure ou égale à 10 % en moles en termes d'un oxyde de celui-ci, la teneur molaire du V est inférieure ou égale à 8 % en moles en termes d'un oxyde de celui-ci, et la teneur molaire du B et du P est inférieure ou égale à 3 % en moles en termes d'oxydes de ceux-ci.

3. Pâte conductrice selon l'une quelconque de la revendication 1 ou 2, dans laquelle la fritte de verre contient au moins un élément sélectionné parmi le groupe en Ti, Co, Nb, Fe, Ni, Al, Zr, Ta, Si, Sn et Sb,
dans laquelle respectivement, une teneur molaire du Ti est inférieure ou égale à 10 % en moles en termes d'un oxyde de celui-ci, une teneur molaire du Co est inférieure ou égale à 9 % en moles en termes d'un oxyde de celui-ci, et une teneur molaire d'au moins un élément sélectionné parmi le groupe en en Ti, Co, Nb, Fe, Ni, Al, Zr, Ta, Si, Sn et Sb respectivement est inférieure ou égale à 3 % en moles en termes d'oxydes de ceux-ci.

4. Pâte conductrice selon l'une quelconque des revendications 1 à 3, dans laquelle une teneur de la fritte de verre est de 1 à 10 % en poids.

5. Pâte conductrice selon l'une quelconque des revendications 1 à 4, dans laquelle la pâte conductrice est une poudre d'Ag.

6. Cellule solaire, comprenant :

un substrat semiconducteur ;
un film antireflet formé sur un côté de la surface principale du substrat semiconducteur, et
des électrodes pénétrant dans le film antireflet,
dans laquelle les électrodes sont formées par frittage de la pâte conductrice selon l'une quelconque des revendications 1 à 5.

# Fig.1

# Fig.2

**Fig.3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011096747 A